(19) Europäisches Patentamt
European Patent Office
Office européen des brevets

(11) **EP 1 977 460 B1**

(12) **EUROPÄISCHE PATENTSCHRIFT**

(45) Veröffentlichungstag und Bekanntmachung des Hinweises auf die Patenterteilung:
**24.06.2009  Patentblatt 2009/26**

(21) Anmeldenummer: **07724277.4**

(22) Anmeldetag: **16.04.2007**

(51) Int Cl.:
*H01L 43/06* *(2006.01)*

(86) Internationale Anmeldenummer:
**PCT/EP2007/003339**

(87) Internationale Veröffentlichungsnummer:
**WO 2007/121885 (01.11.2007 Gazette 2007/44)**

(54) **VERTIKALES HALL-SENSORELEMENT**

VERTICAL HALL SENSOR ELEMENT

ÉLÉMENT DÉTECTEUR HALL VERTICAL

(84) Benannte Vertragsstaaten:
**DE FR GB IT SE**

(30) Priorität: **18.04.2006  DE 102006017910**

(43) Veröffentlichungstag der Anmeldung:
**08.10.2008  Patentblatt 2008/41**

(73) Patentinhaber: **Fraunhofer-Gesellschaft zur Förderung der Angewandten Forschung e.V. 80686 München (DE)**

(72) Erfinder:
• **HOHE, Hans-Peter 91332 Heiligenstadt (DE)**

• **HACKNER, Michael 93155 Hemau OT Haag (DE)**
• **STAHL-OFFERGELD, Markus 91058 Erlangen (DE)**
• **SCHLAG, Ulrich 91056 Erlangen (DE)**

(74) Vertreter: **Schenk, Markus et al Schoppe, Zimmermann, Stöckeler & Zinkler Patentanwälte Postfach 246 D-82043 Pullach (DE)**

(56) Entgegenhaltungen:
**EP-A2- 0 671 773        DE-A1- 10 244 096 JP-A- 2006 024 647**

**Beschreibung**

Die vorliegende Erfindung bezieht sich auf Hall-Sensorelemente und insbesondere auf effektive, vertikale Hall-Sensorelemente mit einer hohen Empfindlichkeit und einem reduzierten Offset-Anteil des Ausgangssignals, die vorzugsweise in CMOS-Technologie implementiert sind.

Auf dem Hall-Effekt basierende Hall-Sensorelemente werden in der Technik neben der Messung eines Magnetfeldes nach Betrag und Vorzeichen, häufig auch für kontaktfreie, berührungslose Signalgeber zur verschleißfreien Erfassung der Stellung von Schaltern oder Stellgliedern eingesetzt. Eine weitere Möglichkeit besteht darin, ein Hall-Sensorelement in der Nähe einer Leiterbahn anzuordnen und den Strom in dieser Leiterbahn über der Fassung des durch den Strom durch die Leiterbahn erzeugten Magnetfelds kontaktlos zu messen. In der praktischen Anwendung haben sich Hall-Sensorelemente insbesondere durch ihre relativ starke Unempfindlichkeit gegenüber äußeren Einflüssen, wie z.B. Verschmutzungen usw., ausgezeichnet.

Ein Hall-Sensorelement ist im allgemeinen aus einem Halbleiterplättchen mit vier Kontaktanschlüssen, die zur elektrischen Verbindung mit einer externen Ansteuerschaltung vorgesehen sind, aufgebaut. Von den vier Kontaktanschlüssen eines Hall-Sensorelements sind zwei Kontaktanschlüsse zur Betriebsstromeinprägung durch den aktiven Halbleiterbereich vorgesehen, während die anderen beiden Kontaktanschlüsse vorgesehen sind, um die Hall-Spannung zu erfassen. Setzt man das von dem Betriebsstrom durchflossene Halbleiterplättchen einem Magnetfeld mit der Induktion $\vec{B}$ aus, so kommt es zu einer Ablenkung der Strombahnen, die durch die auf die bewegten Ladungsträger im magnetischen Feld einwirkende «Lorenz-Kraft" verursacht wird. Die Hall-Spannung ergibt sich somit bei einem anliegenden Magnetfeld senkrecht zur Richtung des Stromflusses in dem aktiven Halbleitergebiet.

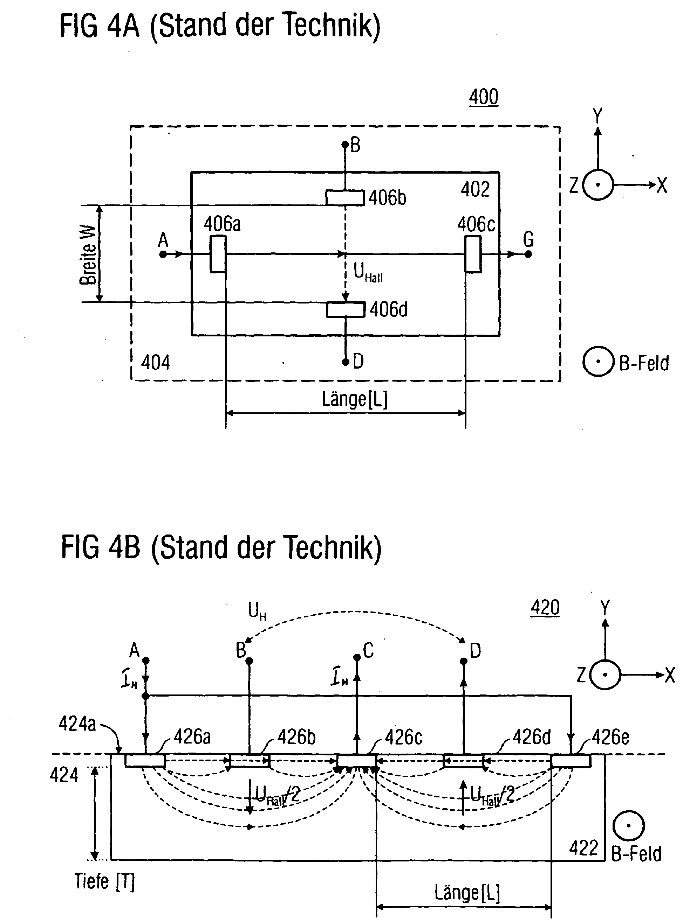

In der Technik sind nun sowohl sogenannte horizontale (laterale) Hall-Sensorelemente als auch vertikale Hall-Sensorelemente bekannt, wobei in Fig. 4a ein horizontales Hall-Sensorelement und in Fig. 4b ein vertikales Hall-Sensorelement gemäß dem Stand der Technik beispielhaft dargestellt sind.

Wie in Fig. 4a prinzipiell dargestellt ist, ist ein horizontales Hall-Sensorelement 400 gemäß dem Stand der Technik im allgemeinen aus einem n-dotierten Halbleiterbereich 402 auf einem p-dotierten Halbleitersubstrat 404 aufgebaut. Als horizontal wird ein Hall-Sensorelement bezeichnet, das parallel zur Chipoberfläche (X-Y-Ebene) angeordnet ist.

Der n-dotierte aktive Bereich 402 ist üblicherweise über vier Kontaktelektroden 406a-d, die jeweils paarweise gegenüber liegend in dem aktiven Bereich 402 angeordnet sind, mit einer externen Ansteuer- bzw. Auswertelogik (nicht gezeigt in Fig. 4a) verbunden. Die vier Kontaktelektroden 406a-d unterteilen sich in zwei gegenüberliegende Steuerstromkontaktelektroden 406a und 406c, die vorgesehen sind, um einen Stromfluss $I_H$ durch den aktiven Bereich 402 zu erzeugen, und ferner in zwei gegenüberliegende Spannungsabgriffkontaktelektroden 406b und 406d, die vorgesehen sind, um eine Hall-Spannung $U_H$, die bei einem anliegenden Magnetfeld $\vec{B}$ senkrecht zu dem Stromfluss in dem aktiven Bereich 402 auftritt, als Sensorsignal abzugreifen.

Wie aus dem in Fig. 4a dargestellten horizontalen Hall-Sensorelement 400 entnehmbar ist, ist der aktive Bereich zwischen den Kontaktanschlüssen 404a-d definiert, so dass der aktive Bereich eine effektive Länge L und eine effektive Breite W aufweist.

Die anhand von Fig. 4a dargestellten horizontalen Hall-Sensorelemente 400 sind relativ einfach mit herkömmlichen CMOS-Prozessen zur Herstellung von Halbleiterstrukturen herstellbar.

Neben den horizontalen Hall-Sensorelementen sind im Stand der Technik ferner Realisierungen sogenannter vertikaler Hall-Sensoranordnungen bekannt, die auch den Einsatz von Standarthalbleiterherstellungstechnologien beispielsweise mittels CMOS-Prozessen ermöglichen. Ein Beispiel für ein vertikales Hall-Sensorelement 420 ist nun prinzipiell anhand von Fig. 4b dargestellt, wobei mit "vertikal" eine Ebene (z.B. Z-Y- oder Z-X-Ebene) senkrecht zur ChipOberfläche (X-Y-Ebene) gemeint ist. Das in Fig. 4b dargestellte im Stand der Technik bekannte, vertikale Hall-Sensorelement geht dabei beispielsweise auf die wissenschaftliche Veröffentlichung von R.S. Popovic, "The Hall-Effect Devices", IEEE ELECTRON DEVICE LETTERS, VOL. EDL-5, NO. 9, SEPTEMBER 1984, zurück. Ein weiteres Beispiel ist die Patentschrift EP671773.

Bei dem in Fig. 4b dargestellten vertikalen Hall-Sensorelement 420 erstreckt sich der vorzugsweise n-dotierte aktive Halbleiterbereich 424 in Form einer Wanne in einen p-dotierten Halbleitersubstrat 424, wobei der aktive Halbleiterbereich 422 eine Tiefe T aufweist. Wie nun in Fig. 4d dargestellt ist, weist das vertikale Hall-Sensorelement fünf Kontaktbereiche 426a-e auf, die angrenzend an die Hauptoberfläche des Halbleitersubstrats 424 in dem selben angeordnet sind, wobei sich die Kontaktanschlüsse 426a-e alle in dem aktiven Halbleiterbereich 422 befinden.

Das in Fig. 4b dargestellte vertikale Hall-Sensorelement 420 weist also fünf Kontaktbereiche 426a-e entlang der Hauptoberfläche des aktiven Halbleiterbereichs 422 auf, wobei die beiden äußeren Kontaktbereiche 426a und 426e, elektrisch miteinander und mit einem Kontaktanschluss A verbunden sind, und wobei der Kontaktbereich 426b mit einem Kontaktanschluss B, der Kontaktbereich 426c mit einem Kontaktanschluss C, und der Kontaktbereich 426d mit einem Kontaktanschluss D verbunden ist. Auf diese Weise können wieder vier Kontaktanschlüsse wie bei einem lateralen Hall-Sensorelement erhalten werden. Dementsprechend werden die Kontaktbereiche 426a, e und 426c verwendet, um einen Stromfluss $I_H$ durch den aktiven Halbleiterbereich 422, d.h. von den Kontaktbereichen 426a, 426e zu dem Kontaktbereich 426c, zu erreichen, wobei die beiden weiteren Kontaktbereiche 426b und 426d zum Abgreifen des resultierenden Sensorsignals, d.h. der Hall-Spannung $U_H$, vorgesehen sind, die bei einem anliegenden Magnetfeld mit der Induktion $\vec{B}$ senkrecht zu dem Stromfluss in dem aktiven Halbleiterbereich 422 auftritt.

Die effektiv wirksamen Bereiche des aktiven Halbleiterbereichs 422 sind durch die Tiefe T des aktiven Halbleiterbereichs 422 und die Länge L entsprechend dem Abstand zwischen den Stromeinspeisungskontaktelektroden 426 c und 426e vorgegeben.

Wie nun in der oben zitierten wissenschaftlichen Veröffentlichung von Popovic angegeben ist, kann die Oberfläche des Bauelements mit Ausnahme der N+-Kontaktbereiche mit einer dünnen Oxidschicht (beispielsweise 100 nm) 428 und einem n+-dotierten Polysilizium-Gatematerial 430 bedeckt sein. Gemäß Popovic werden diese Schichten aus zwei Gründen aufgebracht, nämlich erstens, um eine technologische Kompatibilität mit standardgemäßen Poly-Gate-CMOS-Herstellungsprozessen zu erreichen und um zweitens einen Einfluss auf das Oberflächenpotential und die Oberflächenladungsträgerdichte zu ermöglichen.

Vergleicht man nun anhand der Fig. 4a-b dargestellten horizontalen und vertikalen Hall-Sensorelemente, so entspricht die Breite W des aktiven Halbleiterbereichs 402 des horizontalen Hall-Sensorelements 400 von Fig. 4a der Tiefe T des aktiven Halbleiterbereichs 422 des vertikalen Hall-Sensorelements 420 von Fig. 4b. Die an den den Kontaktbereichen 426b und 426d zugeordneten Kontaktanschlüssen B und D lässt sich nun die Hall-Spannung abgreifen, die entsprechend der nachfolgenden Gleichung berechenbar ist,

$$ U_H = \mu \; \frac{T}{L} \; U_s \; \vec{B}; $$

wobei der Faktor p die Elektronenbeweglichkeit, der Faktor T die Tiefe des aktiven Bereichs 422 des vertikalen Hall-Sensorelements, der Faktor L die effektive Länge des aktiven Bereichs des vertikalen Hall-Sensorelements, der $U_s$, die Steuerspannung und der Faktor $\vec{B}$ das anliegende Magnetfeld darstellt.

Bei gegenwärtig hergestellten, vertikalen Hall-Sensorelementen 420 wird in einem p-Halbleitersubstrat 422 ein n-Typ-Halbleiterbereich in "Wannenform" mit einer vorgegebenen Tiefe hergestellt. Die Tiefe eines solchen vertikalen Hall-Sensorelements entspricht demnach der Tiefe T dieser Wanne 422.

Bei den anhand von Fig. 4b dargestellten vertikalen Hall-Sensorelementen 420 gemäß dem Stand der Technik stellt sich jedoch das Problem, dass die Leitfähigkeit für die Ladungsträger (beispielsweise aufgrund von Oberflächeneffekten) an der Oberfläche des Halbleitermaterials, vorzugsweise Silizium, deutlich höher ist als in tieferen Bereichen des aktiven Halbleiterbereichs 422. Aus diesem Grund fließt ein Großteil des in den Kontaktbereichen 426a und 426e eingeprägten Stroms $I_H$ in der Nähe der Oberfläche 424a des Halbleitersubstrats 424 bzw. des aktiven Bereichs 422 entlang und bei den hochdotierten Kontaktbereichen 426b, 426d, die als Hall-Spannungsabgriff ausgebildet sind, durch diese hindurch, wie dies durch die mit gestrichelten Linien angedeuteten Stromverläufe in Fig. 4b angedeutet ist. Dieser "Kurzschlussstrom" durch die hochdotierten Kontaktbereiche 426b und 426d steht im eigentlich aktiven Halbleiterbereich, d.h. unterhalb der Hall-Spannungs-Abgriffskontakte 426b und 426d in dem aktiven Halbleiterbereich 422, nicht zur Magnetfelderfassung zur Verfügung, so dass dieser Anteil des eingeprägten Betriebsstromes $I_H$ nicht zur Erzeugung der Hall-Spannung $U_H$ beiträgt.

Darüber hinaus sollte bei den anhand von Fig. 4b dargestellten vertikalen Hall-Sensorelementen 420 beachtet werden, dass bei üblichen CMOS-Prozessen zur Herstellung von Halbleiterstrukturen häufig produktionsbedingt Inhomogenitäten oder Störungen in dem Halbleitermaterial des aktiven Halbleiterbereichs 422 auftreten. Diese Inhomogenitäten lassen sich häufig nicht einmal mit aufwendigen Herstellungsverfahren vollständig vermeiden. Diese Inhomogenitäten sind jedoch häufig ein Grund für das Auftreten eines Offsets des Sensorsignals und einer damit verbundenen Verringerung der Messgenauigkeit von vertikalen Hall-Sensorelementen. Von einem Offsetsignal wird gesprochen, wenn an den Kontaktanschlüssen, an denen die Hall-Spannung abgegriffen wird, auch dann ein Sensorsignal erfasst wird, wenn kein Magnetfeld an dem aktiven Halbleiterbereich anliegt. Dieses störende Sensorsignal wird als der Offset des Sensorsignals oder einfach auch als Offset-Signal bezeichnet.

Durch die starke Abhängigkeit des Offset-Signals von den Inhomogenitäten treten bei herkömmlichen vertikalen Hall-Sensorelementen häufig große Exemplarstreuungen auf. Ferner wird die Messgenauigkeit der Hall-Sensorelemente stark beeinträchtigt. Aus diesem Grund ist häufig eine aufwendige Offset-Kompensation und eine aufwendige Auswertung der Sensorsignale mit einem relativ großen schaltungstechnischen Aufwand erforderlich.

Die Patentveröffentlichung JP2006024647A bezieht sich beispielsweise auf ein vertikales Hall-Element und dessen Herstellungsverfahren. Das vertikale Hall-Element weist ein Substrat, mehrere abgegrenzte Halbleiterbereiche mit einem ersten Dotierungstyp in dem Substrat, die durch Isolationsgräben voneinander getrennt sind, auf, wobei der mittlere abgetrennte Halbleiterbereich einen Magnetfelderfassungsabschnitt des vertikalen Hall-Elements darstellt. In dem mittleren Halbleiterbereich sind ein Stromeinprägungsanschluss und ferner zwei Hall-Spannungsabgriffe vorgesehen. In den beiden angrenzenden abgetrennten Halbleiterbereichen ist jeweils ein Stromabgriff vorgesehen, wobei die drei Stromkontakte eine Stromrichtung zwischen denselben definieren, wobei in dem mittleren Halbleiterbereich zwei Hall-Spannungsabgriffe jeweils senkrecht zu der vordefinierten Stromausbreitungsrichtung vorgesehen sind. Der durch den mittleren, abgetrennten Halbleiterbereich gebildete Magnetfelderkennungsabschnitt soll nun eine Magnetfeldkomponente parallel zu der Oberfläche des Substrats und in Richtung zu der Verbindungslinie zwischen den drei Stromkontakten in den drei abgetrennten Halbleiterbereichen erkennen. Im Betrieb fließt der Strom ausgehend von dem Stromkontakt in den mittleren, abgetrennten Halbleiterbereich zunächst in das Halbleitersubstrat hinein, um an den Isolationsgräben vorbei zu den jeweils benachbarten Stromabgriffen in den beiden benachbarten, abgetrennten Halbleiterbereichen. Nur die senkrecht in das Halbleitersubstrat hineinfließende Stromkomponente innerhalb des Magnetfelderkennungsabschnitts ist wirksam, um aufgrund der Lorentzkraft eine Hall-Spannung zwischen den beiden Spannungsabgriffen in dem mittleren, abgetrennten Halbleiterbereich zu erhalten. Um nun eine möglichst senkrecht verlaufende Stromkomponente in das Halbleitersubstrat hinein zu erhalten, ist in dem Halbleitersubstrat unterhalb der Isolationsgräben bei dem Hall-Element eine hochdotierte vergrabene Schicht vorgesehen.

Ausgehend von diesem Stand der Technik besteht die Aufgabe der vorliegenden Erfindung darin, ein verbessertes vertikales Hall-Sensorelement mit einer erhöhten Empfindlichkeit und einem reduzierten Offset-Signal zu schaffen.

Diese Aufgabe wird durch ein vertikales Hall-Sensorelement gemäß Anspruch 1 gelöst.

Die vorliegende Erfindung schafft ein vertikales Hall-Sensorelement mit einem Halbleitersubstrat, einem Halbleiterbereich mit einem ersten Leitfähigkeitstyp, wobei sich der Halbleiterbereich von einer Hauptoberfläche des Halbleitersubstrats in das Substrat erstreckt, eine Mehrzahl von Kontaktbereichen an der Hauptoberfläche in dem halbleiterbereich, und eine Mehrzahl von nicht-leitenden Barrierenbereichen, die sich ausgehend von der Hauptoberfläche in den halbleiterbereich erstrecken, wobei jeweils zwischen benachbarten Kontaktbereichen einer der nicht-leitenden Barrierenbereichen angeordnet ist, und wobei die nicht-leitenden Barrierenbereiche ausgebildet sind, um einen zwischen zwei Kontaktbereichen in den Halbleiterbereich eingespeisten Betriebsstrom entfernt von der Hauptoberfläche zu halten.

Der vorliegenden Erfindung liegt die Erkenntnis zugrunde, dass zusätzliche, nicht-leitfähige Barrierenbereiche, die beispielsweise als p-Typ-Wannenbereiche ausgebildet sind, zwischen den Kontaktbereichen in den aktiven n-Typ-Halbleiterbereich eingebracht werden, um den Betriebsstrom, der zwischen zwei Kontaktbereichen in den Halbleiterbereich eingespeist wird, von der Hauptoberfläche in entfernte Bereiche des aktiven Halbleiterbereichs, d.h. in tiefere Bereiche der aktiven Halbleiterwanne, zu drängen.

Diese Maßnahme führt nun dazu, dass sich der Ausbreitungswiderstand in dem vertikalen Hall-Sensorelement erhöht und sich somit die Stromaufnahme bezogen auf eine konstante Steuerspannung, die zwischen die Kontaktbereiche zum einprägen des Betriebstroms angelegt wird, verringert wird. Durch diese erfindungsgemäße Maßnahme wird die effektive Tiefe des vertikalen Hall-Sensorelements im Bereich unterhalb der Hall-Kontakte, d.h. unterhalb der Kontaktbereiche zum Abgreifen der Hall-Spannung, nicht reduziert. Lediglich im Bereich der Kontaktbereiche für die Stromzuführung auf beiden Seiten kann die Einschnürung aufgrund der zusätzlichen nicht-leitenden Barrierenbereiche zu einer gewissen Verringerung des resultierenden Hall-Signals, d.h. der Hall-Spannung, führen. Diese Verringerung wird aber ausgehend von einer konstanten Versorgungsspannung $U_S$ durch den nunmehr deutlich niedrigeren Versorgungsstrom $I_H$ mehr als kompensiert, so dass durch das erfindungsgemäße Vorsehen der nicht-leitenden Barrierenbereiche ein deutlich effektiveres vertikales Hall-Sensorelement bereit gestellt werden kann, als dies bisher im Stand der Technik möglich war.

Eine mögliche Weiterbildung des erfindungsgemäßen vertikalen Hall-Sensorelements besteht nun darin, z.B. auf einer Isolationsschicht auf dem aktiven Halbleiterbereich, die zumindest die Bereiche für die Kontaktanschlüsse zum Kontaktieren der Kontaktbereiche freilässt, ein Poly-Halbleiter-Material, z.B. ein Polysilizium-Material bzw. Poly-Gate-Material, auf die Isolationsschicht aufzubringen, wobei wieder zumindest die Bereiche für die Kontaktanschlüsse zum Kontaktieren der Kontaktbereiche frei gelassen sind. Dieses Poly-Halbleitermaterial kann nun mit einer geeignet einstellbaren bzw. wählbaren elektrischen Vorspannung (Poly-Vorspannung) versorgt werden, wodurch aufgrund der Beeinflussung der elektrischen bzw. elektronischen Eigenschaften des zugeordneten aktiven Halbleiterbereichs entweder ein vorhandenes Offset-Signal korrigiert werden kann oder die Empfindlichkeit des erfindungsgemäßen vertikalen Hall-Sensorelements geregelt bzw. eingestellt werden kann.

Gemäß einer weiteren Weiterbildung des erfindungsgemäßen vertikalen Hall-Sensorelements können nun anstatt einer gemeinsamen, zusammenhängenden Abdeckung mehrere voneinander unabhängige, benachbarte Teilabdeckungsbereiche auf dem aktiven Halbleiterbereich verwendet werden, die jeweils einzeln mit einer unabhängig einstellbaren Vorspannung ansteuerbar sind, so dass gemäß dieser Vorgehensweise ermöglicht wird, dass eine voneinander unabhängige Kompensation des Offsetsignals bei einer gleichzeitigen Empfindlichkeitsregelung des erfindungsgemäßen Hall-Sensorelements erhalten werden kann.

Bevorzugte Ausführungsbeispiele der Erfindung werden nachfolgend unter Bezugnahme auf die beiliegenden Zeichnungen näher erläutert. Es zeigen:

Fig. 1a-b     eine prinzipielle Darstellung eines vertikalen Hall-Sensorelements gemäß einem ersten Ausführungsbeispiel der vorliegenden Erfindung in einer Querschnittsansicht mit unterschiedlichen Betriebszuständen;

Fig. 2a-b eine prinzipielle Darstellung eines vertikalen Hall-Sensorelements gemäß einem weiteren Ausführungsbeispiel der vorliegenden Erfindung in einer Querschnittsansicht bzw. in Draufsicht;

Fig. 3a-b eine prinzipielle Darstellung eines vertikalen Hall-Sensorelements gemäß einem weiteren Ausführungsbeispiel der vorliegenden Erfindung in einer Querschnittsansicht bzw. in Draufsicht; und

Fig. 4a-b eine beispielhafte Darstellung eines horizontalen und eines vertikalen Hall-Sensorelements gemäß dem Stand der Technik.

Bezüglich der nachfolgenden Ausführungen sollte beachtet werden, dass in den unterschiedlichen Ausführungsbeispielen gleiche oder gleich wirkende Funktionselemente gleiche Bezugszeichen aufweisen und somit in den verschiedenen im Nachfolgenden dargestellten Ausführungsbeispielen untereinander austauschbar sind.

Bezüglich der nachfolgenden detaillierten Beschreibung der unterschiedlichen Ausführungsbeispiele des erfindungsgemäßen vertikalen Hall-Sensorelements wird ferner darauf hingewiesen, dass zu verschiedenen Bereichen die jeweils zugeordneten Dotierungstypen, d.h. n-Typ- bzw. p-Typ-Dotierungen, beispielhaft angegeben sind. Es sollte jedoch bezüglich der nachfolgenden Beschreibung deutlich werden, dass die nachfolgende Beschreibung entsprechend auch auf inverse Polaritäten der angegebenen Dotierungstypen mit den angegebenen Dotierungsdichten anwendbar ist.

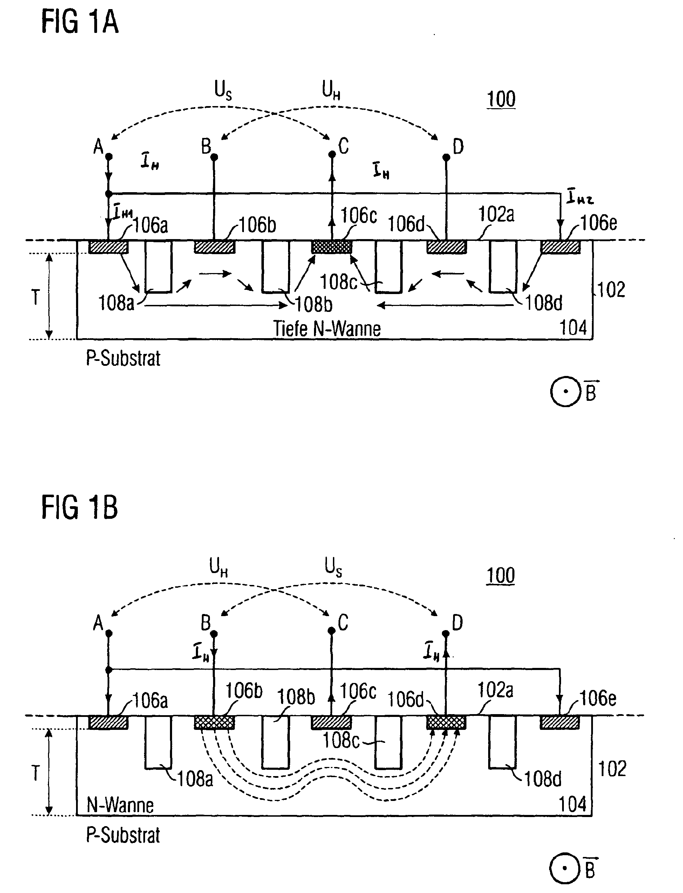

Bezugsnehmend auf Fig. 1a-b wird nun der erfindungsgemäße Aufbau eines vertikalen Hall-Sensorelements 100 gemäß dem ersten Ausführungsbeispiel dargestellt.

Wie nun in Fig. 1a dargestellt ist, weist das erfindungsgemäße vertikale Hall-Sensorelement 100 ein Halbleitersubstrat 102 auf, wobei ein aktiver Halbleiterbereich 104, beispielsweise in Wannenform, mit einer n-Typ-Dotierung mit einer Dotierungsdichte in einem Bereich von etwa $10^{15}$ cm$^{-3}$ in dem Halbleitersubstrat 102 gebildet ist, das beispielsweise wiederum eine p-Typ-Dotierung mit einer typischen Dotierungsdichte in einem Bereich um $10^{15}$ cm$^{-3}$ aufweist. Der aktive Halbleiterbereich erstreckt sich dabei ausgehend von einer Hauptoberfläche 102a des Halbleitersubstrats 102 bis in eine Tiefe T. Typische Werte für die Tiefe T liegen in einem Bereich von 1 bis 10 $\mu$m und vorzugsweise von 3 bis 7 $\mu$m.

Das vertikale Hall-Sensorelement 100 weist ferner eine Mehrzahl von Kontaktbereichen 106a-e auf, die entlang der Hauptoberfläche 102a des Halbleitersubstrats 102 benachbart zueinander in dem aktiven Halbleiterbereich 104 angeordnet sind. Die Kontaktbereiche 106a-e weisen vorzugsweise eine hohe n-Typ-Dotierung ($\geq 10^{19}$ cm$^{-3}$) auf. Ferner sind vier Kontaktanschlüsse A, B, C, D zum Kontaktieren der Kontaktbereiche 106a-e vorgesehen, wobei der Kontaktanschluss A mit den Kontaktbereichen 106a und 106e, der Kontaktanschluss B mit dem Kontaktbereich 106b, der Kontaktanschluss C mit dem Kontaktbereich 106c, und der Kontaktanschluss D mit dem Kontaktbereich 106d verbunden ist. Das vertikale Hall-Sensorelement 100 weist ferner eine Mehrzahl von nicht-leitenden Barrierenbereichen 108a-d auf, die sich ausgehend von der Hauptoberfläche 102a in den aktiven Halbleiterbereich 104 erstrecken. Dabei ist jeweils zwischen zwei benachbarten Kontaktbereichen einer der nicht-leitenden Barrierebereiche angeordnet, wie dies in Fig. 1a-b dargestellt ist. Die nicht-leitenden Barrierenbereiche 108a-d sind nun so ausgebildet, um in der Nähe bzw. an der Hauptoberfläche 102a des aktiven Halbleiterbereich 104 einen Stromfluss zwischen den Kontaktbereichen 106a-e, d.h. zwischen zwei zugeordneten Kontaktbereichen, zu unterbinden. Die nicht-leitenden Barrierenbereiche 108a-d sind also angeordnet, um einen zwischen zwei Kontaktbereichen in den aktiven Halbleiterbereich 104 eingespeisten Betriebsstrom entfernt von der Hauptoberfläche 102a zu halten und in tiefere Regionen des aktiven Halbleiterbereichs 104 zu drängen. Die nicht-leitenden Barrierenbereiche 108a-d sind vorzugsweise möglichst symmetrisch bezüglich der Kontaktbereiche 106a-d angeordnet, um einen resultierenden (systematischen) Offset-Fehler des Messsignals $U_H$ möglichst gering zu halten.

Die nicht-leitenden Barrierenbereiche 108a-d sind gemäß der vorliegenden Erfindung vorzugsweise als p-Typ-Halbleiterbereiche (p-Typ-Wannen) ausgebildet, um in übliche Halbleiterherstellungsprozesse und insbesondere CMOS-Prozess integrierbar zu sein. Bezüglich der Abmessungen der nicht-leitenden Barrierenbereichen 108a-d (p-Typ-Wannen) sollte beachtet werden, dass sich diese beispielsweise mehr als 25 % und vorzugsweise mehr als 60 % (und maximal etwa 90 %) bezüglich der Tiefe T des aktiven Halbleiterbereichs 104 in denselben erstrecken. Es sollte lediglich beachtet werden, dass die nicht-leitenden Barrierenbereiche 108a-d den Stromtransport zwischen den verschiedenen Kontaktbereichen 106a-e nicht unterbinden dürfen.

Die Breite der nicht-leitenden Barrierenbereiche 108a-d ist gemäß der vorliegenden Erfindung i.w. unkritisch, solange die Stromverteilung des Betriebstrom $I_H$ an den als Stromeinprägekontakten wirksamen Kontaktbereichen bzw. in deren Umgebung nicht zu stark eingeengt wird. Vorteilhaft ist es aber, die nicht-leitenden Barrierenbereiche 108a-d so schmal wie möglich auszubilden, d.h. so schmal, wie dies die Herstellungstechnologie zulässt. Der Strom sollte zwar nach unten in den aktiven Halbleiterbereich 104 abgedrängt werden, aber der Bereich unmittelbar unter der "Barriere" ist eigentlich ein magnetisch inaktiver Bereich, der nicht zum Hall-Signal beiträgt. Typische erreichbare Werte für die Breite der nicht-leitenden Barrierenbereiche 108a-d liegen Technologie-bedingt in einer Größenordnung etwa des 1- bis 1,5-fachen der Eindringtiefe der nicht-leitenden Barrierenbereiche 108a-d in den aktiven Halbleiterbereich 104.

Wie bei dem ersten bevorzugten Ausführungsbeispiel des erfindungsgemäßen vertikalen Hall-Sensorelements 100 in Fig. 1a dargestellt ist, sind die beiden entgegengesetzten Kontaktbereiche 106a und 106e beispielsweise schaltungstechnisch miteinander verbunden, so dass zur Kontaktierung der fünf Kontaktbereiche 106a-e vier Kontaktanschlüsse A, B, C, D erforderlich sind. Es sollte deutlich werden, dass auch eine andere Anordnung der Kontaktanschlüsse vorgesehen werden kann, beispielsweise um jeden Kontaktbereich einzeln zu verbinden. Das erfindungsgemäße Konzept ist aber dann besonders vorteilhaft einsetzbar, wenn das erfindungsgemäße vertikale Hall-Sensorelement in Verbindung mit der sogenannten Spinning-Current-Technik eingesetzt werden kann, wobei dazu eine symmetrische Anzahl von Kontaktanschlüssen und vorzugsweise vier Kontaktanschlüsse erforderlich sind, um die Spinning-Current-Technik beispielsweise mit mehreren parallel geschalteten (vorzugsweise identischen) vertikalen Hall-Sensorelementen 100 durchführen zu können.

Die Spinning-Current-Technik besteht nun darin, die Messrichtung zur Erfassung der Hall-Spannung an dem Hall-Sensorelement ständig mit einer bestimmten Taktfrequenz um beispielsweise 90˚ zyklisch weiter zu drehen und über alle Messsignale einer vollen Drehung um 360˚ aufzusummieren. Bei einem Hall-Sensorelement mit vier Kontaktbereichen, von denen jeweils zwei Kontaktbereiche paarweise zueinander zugeordnet sind, wird daher jedes der Kontaktpaare je nach Spinning-Current-Phase sowohl als Steuerstromkontaktbereiche zur Stromeinspeisung als auch als Messkontaktbereiche zum Abgreifen des Hall-Signals genutzt. So fließt in einer Spinning-Current-Phase bzw. in einem Spinning-Current-Zyklus der Betriebsstrom (Steuerstrom $I_H$) zwischen zwei zugeordneten Kontaktbereichen, wobei die Hall-Spannung an den beiden anderen einander zugeordneten Kontaktbereichen abgegriffen wird.

Beim nächsten Zyklus wird dann die Messrichtung um 90˚ weitergedreht, so dass die Kontaktbereiche, die im vorangehenden Zyklus zum Abgreifen der Hall-Spannung eingesetzt wurden, nunmehr zur Einspeisung des Steuerstroms dienen. Durch die Summation über alle vier Zyklen bzw. Phasen heben sich herstellung- oder materialbedingte Offset-Spannungen annähernd gegenseitig auf, so dass nur die tatsächlich magnetfeldabhängigen Anteile des Signals übrig bleiben. Diese Vorgehensweise ist natürlich auch auf eine größere Anzahl von Kontaktpaaren anwendbar, wobei beispielsweise bei vier Kontaktpaaren (mit acht Kontaktbereichen) die Spinning-Current-Phasen um 45˚ zyklisch weiter gedreht werden, um alle Messsignale über einer vollen Drehung um 360˚ aufsummieren zu können.

In Fig. 1a ist nun eine Phase der oben erläuterten Spinning-Current-Technik dahingehend dargestellt, dass die Anschlusskontakte A und C zum Einspeisen des Steuer- bzw. Betriebsstroms $I_H$ vorgesehen sind, wobei die Anschlusskontakte B und D mit dem zugeordneten Kontaktbereichen 106b und 106d zum abgreifen der Hall-Spannung $U_H$ vorgesehen sind. Wie in Fig. 1a bezüglich des erfindungsgemäßen vertikalen Hall-Sensorelements 100 dargestellt ist, wird zwischen die Kontaktanschlüsse A und C eine Steuerspannung $U_S$ angelegt, wodurch sich aufgrund des resultierenden Widerstands zwischen dem ersten Kontaktbereich 106a und dem Kontaktbereich 106c und zwischen dem Kontaktbereich 106e und dem Kontaktbereich 106c jeweils ein Betriebsstromanteil $I_{H1}$ und $I_{H2}$ einstellt, der vorzugsweise gleich groß sein sollte und somit jeweils dem halben Gesamtbetriebsstrom $I_H$ entspreche sollte. Je nach Polarität der Steuerspannung $U_S$ kann die resultierende Stromrichtung $I_H$ und die resultierende Hall-Spannung $U_H$ auch entgegengesetzt zu der Darstellung in Fig. 1a verlaufen.

Wie nun der in Fig. 1a eingezeichneten Stromverteilung zu entnehmen ist, wird durch die erfindungsgemäßen nicht-leitenden Barrierenbereiche 108a-d erreicht, dass sich die Stromanteile $I_{H1}$ und $I_{H2}$ nicht entlang der Oberfläche 102a des Halbleitersubstrats 102 bewegen, sondern entfernt von dieser Hauptoberfläche 102a in dem aktiven Halbleiterbereich 104 gehalten werden.

Bei Vorliegen eines Magnetfeldes mit der Induktion $\vec{B}$ parallel zu der Hauptoberfläche 102a des Halbleitersubstrats 102 wie dies beispielsweise in Fig. 1a schematisch dargestellt ist, stellt sich eine Hall-Spannung $U_H$ zwischen den Kontaktanschlüssen B und D ein, die mit dem Doppelpfeil zwischen diesen beiden Kontaktanschlüssen angedeutet ist. Durch Abgreifen der beiden Kontaktanschlüsse B und D kann die Hall-Spannung $U_H$ gemessen und daraus die Größe des Magnetfeldes $\vec{B}$ ermittelt werden.

In Fig. 1b ist nun das erfindungsgemäße vertikale Hall-Sensorelement 100 dargestellt, das sich nun beispielsweise in der nächsten Spinning-Current-Phase befindet, wobei der Steuerstrom $I_H$ zwischen den beiden Kontaktanschlüssen B und D mit dem zugeordneten Kontaktbereichen 106b und 106d verläuft, wobei sich daraus der prinzipiell in Fig. 1b resultierende Stromverlauf $I_H$ zwischen den beiden Kontaktbereichen 106b und 106d ergibt. Entsprechend ist nun die resultierende Hall-Spannung über den beiden Kontaktanschlüssen A und C mit den zugeordneten Kontaktbereichen 106a, 106e und 106c abgreifbar. Auch hier sind die erfindungsgemäßen nicht-leitenden Barrierenbereiche 108b und 108c wirksam, um zu erreichen, dass die sich ausbildende Stromverteilung $I_H$ nicht in der Nähe der Hauptüberfläche 102a des Halbleitersubstrats 102 bzw. des aktiven Halbleiterbereichs 104 befindet.

Die unterschiedlichen, resultierenden Steuerstromverteilungen in dem aktiven Halbleiterbereich 104 in den beiden unterschiedlichen Spinning-Current-Phasen sind aus den Fig. 1a-b unter der vorteilhaften Verwendung der erfindungsgemäßen nicht-leitenden Barrierenbereiche 108a-d schematisch zu entnehmen. Die weiteren (zwei) verbleibenden Spinning-Current-Phasen ergeben sich analog aus den beiden im Vorhergehenden dargestellten Spinning-Current-Phasen durch Umkehrung der Strom- und Spannungsrichtungen an den zugeordneten Kontaktanschlüssen. So kann je nach Polarität der Steuerspannung $U_S$ die resultierende Stromrichtung $I_H$ und Hall-Spannung $U_H$ auch entgegengesetzt zu den Darstellungen in Fig. 1a-b verlaufen, wobei die sich einstellende Hall-Spannung auch vom Dotierungstyp des aktiven Halbleiterbereichs abhängt.

Das erfindungsgemäße vertikale Hall-Sensorelement 100 mit den zusätzlichen nicht-leitenden Barrierenbereichen 108a-d, die vorzugsweise als p-Typ-Wannen in dem aktiven n-Typ-Halbleiterbereich 104 ausgebildet und zwischen den jeweiligen Kontaktbereichen 106a-e angeordnet sind, erreicht somit, dass sich die Stromverteilung des Betriebsstroms $I_H$ (bzw. der Stromanteile $I_{H1}$ und $I_{H2}$) des dargestellten vertikalen Hall-Sensorelements 100 von der Hauptoberfläche 102a entfernt und in "tieferen" Bereichen des aktiven Halbleiterbereichs 104 verläuft.

Dies führt dazu, dass der resultierende Widerstand in dem vertikalen Hall-Sensorelement 100 gegenüber herkömmlichen Sensorelementen erhöht wird und sich somit die Stromaufnahme bezüglich einer vorgegebenen Steuerspannung $U_S$ stark reduziert. Dabei wird aber die Tiefe, d.h. der wirksame aktive Halbleiterbereich des vertikalen Hall-Sensorelements in den Abschnitten unterhalb der Hall-Kontaktbereiche zum Abgreifen des Hall-Signals, d.h. der Hall-Spannung zwischen zwei benachbarten nicht-leitenden Barrierenbereichen, im wesentlichen nicht verringert. Lediglich in den Abschnitten der als jeweilige Stromzuführung ausgebildeten Kontaktbereiche auf beiden Seiten kann die (mögliche) Einschnürung der Stromverteilung durch die Barrierenbereiche 108a-d zu einer Verringerung des resultierenden Hall-Signals, d.h. der Hall-Spannung, führen. Diese Verringerung wird aber durch den jetzt deutlich niedrigeren Versorgungsstrom (Betriebsstrom $I_H$) mehr als kompensiert, so dass erfindungsgemäß ein deutlich effektiveres Hall-Sensorelement bereit gestellt werden kann, als dies bisher im Stand der Technik möglich war.

Bezüglich des erfindungsgemäßen Vorsehens der zusätzlichen nicht-leitenden Barrierenbereiche 108a-d sollte aber beachtet werden, dass in einigen Fällen, technologiebedingt ein zusätzlicher systematischer Offset-Fehler auftreten kann. Diesen systematischen Fehler kann aber mit den im nachfolgenden dargestellten vorteilhaften Weiterbildungen des erfindungsgemäßen vertikalen Hall-Sensorelements 100 effektiv entgegengewirkt werden.

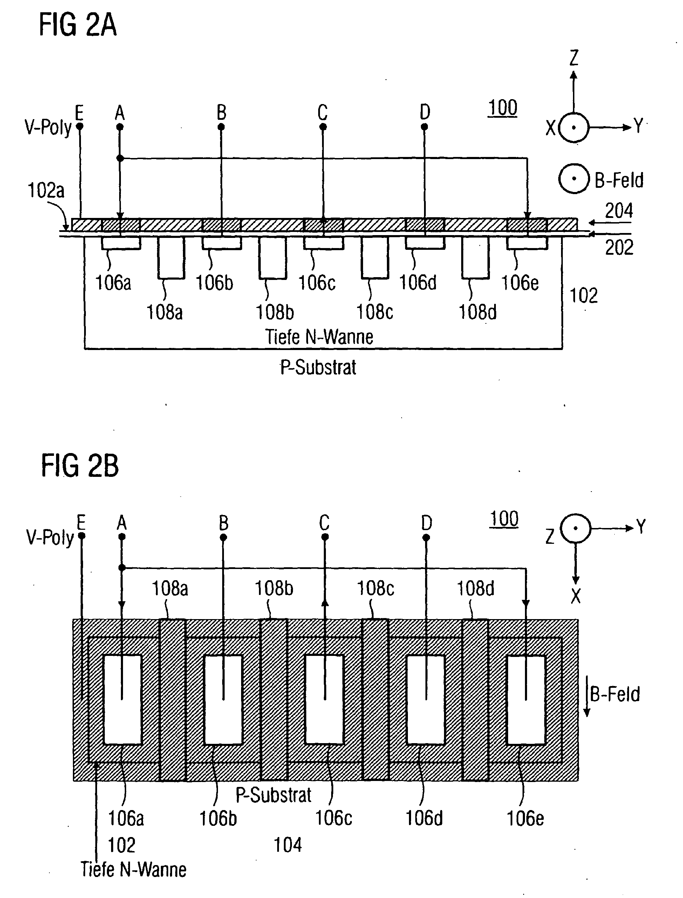

In den weiteren Fig. 2a-b wird nun eine erfindungsgemäße Weiterbildung des im vorhergehenden dargestellten vertikalen Hall-Sensorelements 100 und dessen Funktionsweise erläutert, wobei im Folgenden gleiche oder gleich wirkende Funktionselemente wieder gleiche Bezugszeichen aufweisen, wobei auf eine erneute detaillierte Erläuterung dieser Funktionselemente zur Vereinfachung der Beschreibung verzichtet wird.

Bezüglich des in den Fig. 2a-b in Querschnitt und Draufsicht dargestellten weiteren Ausführungsbeispiels des erfindungsgemäßen vertikalen Hall-Sensorelements 100 wird deutlich, dass zumindest auf dem aktiven Halbleiterbereich 104 und beispielsweise auch (falls vorhanden) auf das seitlich angrenzende Material des Halbleitersubstrats 102 auf die Hauptoberfläche 102a eine Isolationsschicht 202 aufgebracht ist, wobei zumindest ausreichend große Bereiche für die Kontaktanschlüsse A - D zum Kontaktieren der Kontaktbereiche 106a-e freigelassen sind.

Die Isolationsschicht (bevorzugt Gate-Oxid) weist beispielsweise eine Dicke von 5 bis 20 nm und vorzugsweise eine Dicke in einem Bereich um 10 nm auf. Die Dicke der Isolationsschicht hängt insbesondere von der verwendeten Technologie ab, wobei z.B. bei einer $0,8\mu m$ CMOS-Technologie eine resultierende Gate-Oxid-Dicke von etwa 15 nm und bei einer $0,35\mu m$ CMOS-Technologie eine resultierende Gate-Oxid-Dicke von etwa 7,6 nm erhalten wird. Aus Kompatibilitätsgründen bezüglich üblicher CMOS-Herstellungsprozesse wird beispielsweise ein $SiO_2$-Material für die Isolationsschicht 202 bevorzugt eingesetzt.

Auf der Isolationsschicht 202 ist nun eine Abdeckungsschicht 204 aus einem Poly-Halbleitermaterial, vorzugsweise einem Polysilizium-Material (Poly-Gate-Material) mit einer n-Typ-Dotierungskonzentration von $\geq 10^{19}$ cm$^{-3}$ aufgebracht, wobei zumindest die Bereiche für die Kontaktanschlüsse A - D zu den Kontaktierungsbereichen 106a-e freigelassen sind. Ferner ist diese zusätzliche Poly-Abdeckungsschicht über einen weiteren Kontaktanschluss E ansteuerbar, um die zusätzliche Poly-Abdeckungsschicht 204 auf ein vorgegebenes bzw. einstellbares Potential $V_{POLY}$ bezüglich des aktiven Halbleiterbereichs 104 zu legen.

Die zusätzliche Abdeckungsschicht 204 kann beispielsweise mit herkömmlichen CMOS-Prozessen zur Herstellung von Halbleiterstrukturen aufgebracht werden, wobei die Abdeckungsschicht 204 vorzugsweise gleichzeitig mit den CMOS-Herstellungsschritten für Gate-Bereiche aus einem Poly-Halbleitermaterial und vorzugsweise aus einem Poly-Siliziummaterial (Poly-Gate-Material) hergestellt wird.

Durch das "geeignete" Einstellen der Vorspannung der Poly-Abdeckung 204 lassen sich die Eigenschaften des erfindungsgemäßen vertikalen Hall-Sensorelements 200 bezüglich des resultierenden Offset-Signals und der Empfindlichkeit günstig beeinflussen.

Durch das Anlegen der Vorspannung $V_{Poly}$ an die Poly-Abdeckung 204 können die Oberflächenladung bzw. die Oberflächenladungsdichte in dem aktiven Halbleiterbereich 104 ähnlich dem Funktionsprinzip von CMOS-Transistoren beeinflusst werden. Insbesondere können aber durch die Poly-Vorspannung auch die elektrischen Eigenschaften des aktiven Halleiterbereichs 104 und damit die Ladungsträgerverteilungen im gesamten Volumen des aktiven Halbleiterbereichs 104 gezielt beeinflusst werden.

So kann einerseits durch die Poly-Vorspannung in den Kontaktbereichen 106a-e, die (z.B. während einer bestimmten Spinning-Current-Phase) als Kontaktbereiche zur Stromeinprägung wirksam sind, die Leitfähigkeit des aktiven Halbleiterbereichs 104 in der Umgebung dieser Kontaktbereiche beeinflusst werden, wobei sich aus einer Einstellung einer hohen Leitfähigkeit in dem Halbleitermaterial in der Umgebung der zur Stromeinprägung vorgesehenen Kontaktbereiche eine hohe Empfindlichkeit des vertikalen Hall-Sensorelements 100 erhalten lässt.

Darüber hinaus sollte beachtet werden, dass auch durch die Einstellung der Vorspannung an der Abdeckungsschicht 204 das Offset-Signal beeinflusst bzw. kompensiert werden kann, da sich herausgestellt hat, dass der Offset-Verlauf in Abhängigkeit von der angelegten Vorspannung $V_{POLY}$ einen Nulldurchgang hat, so dass eine vollständige Offset-Kompensation über die Einstellung der Vorspannung $V_{POLY}$ möglich ist. Darüber hinaus sollte beachtet werden, dass die Vorspannung $V_{POLY}$ entsprechend den Spinning-Current-Phasen an der Abdeckungsschicht verändert bzw. eingestellt werden kann, um die Funktionalität der Kontaktbereiche, die in unterschiedlichen Spinning-Current-Phasen eine unterschiedliche Funktion als Stromeinprägungskontaktbereich oder als Spannungsabgriffskontaktbereich aufweisen, hinsichtlich der resultierenden Empfindlichkeit bzw. der effektiven Kompensation des resultierenden Offsetsignals zu optimieren.

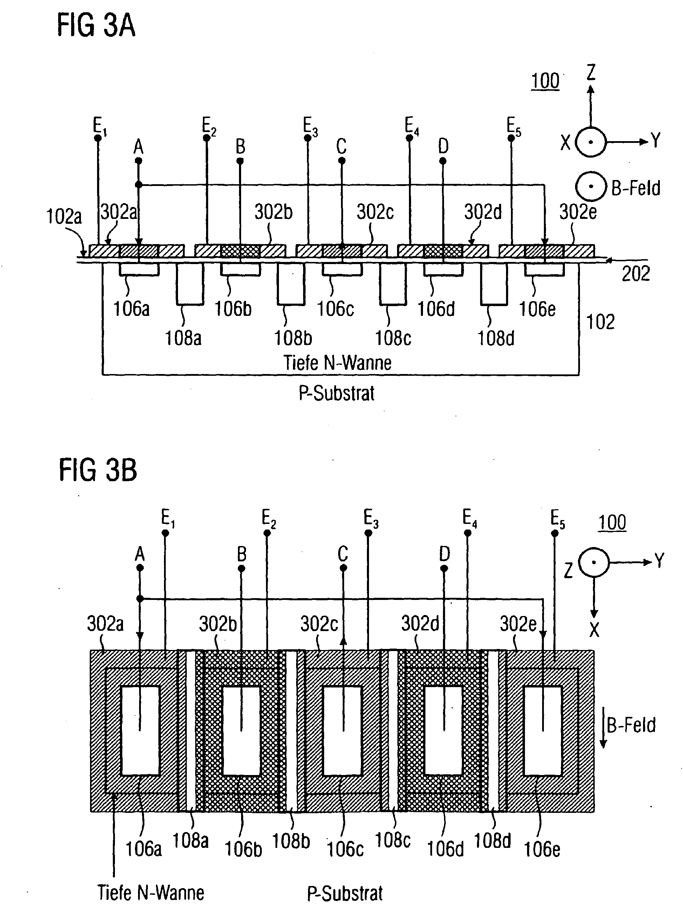

Im Folgenden wird nun anhand der Fig. 3a-b, die in Querschnittsansicht und in Draufsicht eine weitere Ausgestaltung des erfindungsgemäßen vertikalen Hall-Sensorelements 100 darstellen, ein weiteres bevorzugtes Ausführungsbeispiel dargestellt.

Wie in den Fig. 3a-b dargestellt ist, ist bei dem dort dargestellten erfindungsgemäßen vertikalen Hall-Sensorelement 100 die Poly-Abdeckung in eine Mehrzahl von benachbarten, elektrisch getrennten Teilabdeckungsbereichen 302a-e unterteilt, wobei jedem Kontaktbereich 106a-e des vertikalen Hall-Sensorelements 100 und dem sich darunter befindlichen Abschnitt des aktiven Halbleiterbereichs 104 einer der Teilabdeckungsbereiche 302a-e zugeordnet ist. Wie in den Fig. 3a-b dargestellt ist, ist nun jeder Teilabdeckungsbereich 302a-e über einen zugeordneten Kontaktanschluss E1 - E5 mit einer Vorspannung $V_{POLY1}$ - $V_{POLY5}$ getrennt ansteuerbar.

Bezüglich der vorliegenden Erfindung sollte aber beachtet werden, dass natürlich auch nur bestimmte Kontaktanschlüsse bzw. bestimmte Kombinationen der Kontaktanschlüsse mit einer Vorspannung bzw. getrennten Vorspannungen ansteuerbar sein brauchen, um den erfindungsgemäßen Effekt einer Offset-Reduzierung bei einer gleichzeitigen Empfindlichkeitseinstellung zu erhalten.

Der Abstand zwischen den in Fig. 3a-b dargestellten Teilabdeckungsbereichen 302a-d ist nun vorzugsweise kleiner oder gleich der Breite der nicht-leitenden Barrierenbereiche 108a-d gewählt, so dass die Teilabdeckungsbereiche die entsprechenden nicht-leitenden Barrierenbereiche teilweise überlappen.

Bei dem erfindungsgemäßen vertikalen Hall-Sensorelement 100, das in Verbindung mit den Fig. 2a-b beschrieben wurde, und das einen zusammenhängenden, relativ großen Poly-Abdeckungsbereich 204 aufweist, wirkt sich das Anlegen der Poly-Vorspannung im wesentlichen immer gleichzeitig auf das resultierende Offset-Signal und die Empfindlichkeit des Hall-Sensorelements aus.

Gemäß der in den Fig. 3a-b dargestellten Weiterbildung des erfindungsgemäßen vertikalen Hall-Sensorelements 100 wird der Abdeckungsbereich in die einzelnen, benachbarten und elektrisch voneinander getrennten Teilabdeckungsbereiche 302a-e unterteilt, wobei vorzugsweise jeder der Teilabdeckungsbereiche 302a-e über den zugeordneten Kontaktanschluss E1 - E5 mit einer eigenen Vorspannung $V_{POLY1}$ - $V_{POLY5}$ ansteuerbar ist. Damit kann das in den Fig. 3a-b dargestellte erfindungsgemäße Hall-Sensorelement 100 so betrieben werden, dass sowohl das resultierende Offset-Signal möglichst vollständig kompensiert wird als auch eine unabhängige Empfindlichkeitsregelung vorgenommen werden kann.

Das störende Offset-Signal entsteht hauptsächlich in dem Abschnitt des aktiven Halbleiterbereichs 104 unterhalb des jeweiligen Hall-Kontaktbereichs zum Abgreifen des Hall-Signals (der Hall-Spannung $U_A$). Mit Hilfe der Poly-Vorspannung in diesem Poly-Bereich lässt sich das resultierende Offset-Signal im wesentlichen vollständig kompensieren. Wenn man nun von einer Ansteuerung der Kontaktanschlüsse A - D des in den Fig. 3a-b dargestellten erfindungsgemäßen Hall-Sensorelements 100 ausgeht, bei der die Kontaktanschlüsse A und C mit den zugehörigen Kontaktbereichen 106a, 106e und 106c zur Betriebsstromeinspeisung vorgesehen sind, wobei die Kontaktanschlüsse E und D mit den zugeordneten Kontaktbereichen 106b und 106d zum Hall-Spannungsabgriff vorgesehen sind, lässt sich mit Hilfe der Einstellung der Poly-Vorspannung für die Poly-Bereiche 302b und 302d das resultierende Offset-Signal im wesentlichen vollständig kompensiert. Die Abschnitte des aktiven Halbleiterbereichs 104 unterhalb der Steuerspannungskontaktbereiche 106a, 106e und 106c tragen dagegen kaum zu der resultierenden, erfassten Hall-Spannung bei, da diese nur Widerstände darstellen, die den Stromfluss reduzieren. Durch Anlegen einer "geeignet eingestellten" Poly-Vorspannung in diesem Bereich bzw. in diesen Bereichen 302a, 302c, 302e bildet sich ein leitfähiger Kanal in dem aktiven Halbleiterbereich 104 des Halbleitersensorelementes, der den Widerstand in diesem Abschnitt in diesen Abschnitten des aktiven Halbleiterbereichs 104 deutlich reduziert und so die Empfindlichkeit des erfindungsgemäßen vertikalen Halbleiter-Sensorelements weiter erhöht.

Mit den getrennten Teilabdeckungsbereichen 302a-d ist somit erfindungsgemäß eine gezielte Einstellung der elektrischen Eigenschaften, z.B. in Form einer Widerstandseinstellung ΔR, in den zugeordneten Teilabschnitten des aktiven Halbleiterbereichs möglich.

Bezüglich des getrennten Anlegens in der Poly-Vorspannung an einzelne bzw. mehrere Kontaktbereiche 106a-e des erfindungsgemäßen vertikalen Hall-Sensorelements 100 sollte beachten werden, dass im wesentlichen beliebige Ansteuerkombinationen denkbar sind, da eine Poly-Vorspannung über einen Kontaktbereich, der zum Hall-Spannungsabgriff vorgesehen ist, auch Auswirkungen auf die Empfindlichkeit hat, wobei entsprechend auch eine Poly-Vorspannung über einen Kontaktbereich, der als Ansteuerkontakt verwendet wird, Auswirkungen auf das resultierende Offset-Signal hat.

Darüber hinaus sollte beachtet werden, dass die getrennte Ansteuerung der einzelnen Poly-Abdeckungsbereiche 302a-e besonders vorteilhaft auf unterschiedliche Spinning-Current-Phasen angewendet werden kann, so dass insbesondere bei einer Parallelschaltung mehrerer erfindungsgemäßer vertikaler Hall-Sensorelemente 100 beispielsweise Asymmetrien ausgeglichen werden können, wie sie bezüglich der in den Fig. 1a-b dargestellten unterschiedlichen Stromverteilungen in dem aktiven Halbleiterbereich 104 in unterschiedlichen Spinning-Current-Phasen auftreten (können). Bezüglich der vorhergehenden Ausführungen zu den erfindungsgemäßen Ausführungsbeispielen der dargestellten vertikalen Hall-Sensorelemente 100 sollte beachtet werden, dass die dargestellten Polaritäten der Dotierungen auch überall invers verwendet werden können.

**Patentansprüche**

1. Vertikales Hall-Sensorelement (100), mit folgenden Merkmalen:

    einem Halbleitersubstrat (102);
    einem Halbleiterbereich (104) mit einem ersten Leitfähigkeitstyp, wobei sich der Halbleiterbereich (104) von einer Hauptoberfläche (102a) des HalbleiterSubstrats (102) in das Substrat (102) erstreckt;
    einer Mehrzahl von Kontaktbereichen (106a - e) an der Hauptoberfläche (102a) in dem Halbleiterbereich (104);
    einer Mehrzahl von nicht-leitenden Barrierenbereichen (108a-d), die sich ausgehend von der Hauptoberfläche (102a) in den Halbleiterbereich (104) erstrecken, wobei zwischen benachbarten Kontaktbereichen einer der nicht-leitenden Barrierenbereiche angeordnet ist, und wobei die nicht-leitenden Barrierenbereiche (108a - d) ausgebildet sind, um einen zwischen zwei Kontaktbereichen in dem Halbleiterbereich (104) eingespeisten Betriebsstrom $I_H$ entfernt von der Hauptoberfläche (102a) zu halten; und einer Abdeckungsschichtanordnung (204; 302a-e) aus einem leitfähigen Material, die über der Hauptoberfläche (102a) des Halbleitersubstrats (102) mit dem Halbleiterbereich (104) und elektrisch getrennt von dem Halbleiterbereich (104) angeordnet ist, wobei zumindest Bereiche für Kontaktanschlüsse (A - D) zum Kontaktieren der Kontaktbereiche (106a - e) freigelassen sind, und wobei die Abdeckungsschichtanordnung (204; 302a-d) durch Anlegen einer Vorspannung ansteuerbar ist;
    wobei das Halbleitersubstrat (102) einen zweiten Leitfähigkeitstyp aufweist, **gekennzeichnet dadurch, dass** der Halbleiterbereich 104 in Form einer Wanne ausgehend von der Hauptoberfläche (102a) des Halbleitersubstrats (102) in dem Halbleitersubstrat (102) gebildet ist.

2. Vertikales Hall-Sensorelement nach einem der Ansprüche 1, wobei der nicht-leitfähige Barrierenbereich (108a-d) den zweiten Leitfähigkeitstyp aufweist.

3. Vertikales Hall-Sensorelement nach Anspruch 2, wobei sich der nicht-leitende Barrierenbereich (108a - d) in eine Tiefe von mehr als 25 % der Tiefe T des Halbleiterbereichs (104) erstreckt.

4. Vertikales Hall-Sensorelement gemäß einem der vorhergehenden Ansprüche, wobei die Abdeckungsschichtanordnung (204; 302a-d) eine Mehrzahl von benachbarten, elektrisch getrennten Teilabdeckungsbereichen (302a-e) aufweist, wobei jedem Kontaktbereich (106a-e) ein Teilabdeckungsbereich (302a-e) zugeordnet ist.

5. Vertikales Hall-Sensorelement gemäß einem der vorhergehenden Ansprüche, wobei zwischen dem Halbleiterbereich (104) und der Abdeckungsschichtanordnung eine Isolationsschicht (202) angeordnet ist.

6. Verfahren zur Magnetfelderfassung mit einem vertikalen Hall-Sensorelement gemäß einem der vorhergehenden Ansprüche, mit folgenden Schritten:

    Ansteuern der Abdeckungsschichtanordnung durch Anlegen einer Vorspannung an derselben.

7. Verfahren gemäß Anspruch 6, ferner mit folgendem Schritt:

Umschalten der Kontaktbereiche (106a-e) im Spinning-Current-Betrieb, so dass dieselben je nach Spinning-Current-Betriebsphase als Strom- oder Spannungsabgriff wirksam sind.

8. Vertikales Hall-Sensorelement (100), mit folgenden Merkmalen:

einem Halbleitersubstrat (102);
einem Halbleiterbereich (104) mit einem ersten Leitfähigkeitstyp, wobei sich der Halbleiterbereich (104) von einer Hauptoberfläche (102a) des HalbleiterSubstrats (102) in das Substrat (102) erstreckt;
einer Mehrzahl von Kontaktbereichen (106a - e) an.der Hauptoberfläche (102a) in dem Halbleiterbereich (104);
einer Mehrzahl von nicht-leitenden Barrierenbereichen (108a-d), die sich ausgehend von der Hauptoberfläche (102a) in den Halbleiterbereich (104) erstrecken, wobei zwischen jedem Paar der benachbarten Kontaktbereiche einer der nicht-leitenden Barrierenbereiche angeordnet ist, und wobei die nicht-leitenden Barrierenbereiche (108a - d) ausgebildet sind, um einen zwischen zwei Kontaktbereichen in dem Halbleiterbereich (104) eingespeisten Betriebsstrom $I_H$ entfernt von der Hauptoberfläche (102a) zu halten; und **gekennzeichnet durch**
einer Mehrzahl von benachbarten, elektrisch getrennten Teilabdeckungsbereichen (302a-e) aus einem leitfähigen Material über dem Halbleiterbereich (104) und elektrisch getrennt von demselben, wobei mehrere der Teilabdeckungsbereiche **durch** Anlegen einer getrennten Vorspannung getrennt ansteuerbar sind.

9. Vertikales Hall-Sensorelement nach Anspruch 8, wobei das Halbleitersubstrat (102) einen zweiten Leitfähigkeitstyp aufweist, wobei der Halbleiterbereich 104 in Form einer Wanne ausgehend von der Hauptoberfläche (102a) des Halbleitersubstrats (102) in dem Halbleitersubstrat (102) gebildet ist.

10. Vertikales Hall-Sensorelement nach Anspruch 8 oder 9, wobei der nicht-leitfähige Barrierenbereich (108a-d) den zweiten Leitfähigkeitstyp aufweist.

11. Vertikales Hall-Sensorelement nach Anspruch 10, wobei sich der nicht-leitende Barrierenbereich (108a - d) in eine Tiefe von mehr als 25 % der Tiefe T des Halbleiterbereichs (104) erstreckt.

12. Vertikales Hall-Sensorelement gemäß einem der Ansprüche 8 bis 11, wobei jedem Kontaktbereich (106a-e) ein Teilabdeckungsbereich (302a-e) zugeordnet ist.

13. Vertikales Hall-Sensorelement gemäß einem der Ansprüche 8 bis 12, wobei zwischen dem Halbleiterbereich (104) und den Teilabdeckungsbereichen eine Isolationsschicht (202) angeordnet ist.

14. Verfahren zur Magnetfelderfassung mit einem vertikalen Hall-Sensorelement gemäß einem der Ansprüche 8 bis 13, mit folgenden Schritten:

Getrenntes Ansteuern mehrerer der Teilabdeckungsbereiche durch Anlegen einer getrennten Vorspannung an dieselben.

15. Verfahren gemäß Anspruch 14, ferner mit folgendem Schritt:

Umschalten der Kontaktbereiche (106a-e) im Spinning-Current-Betrieb, so dass dieselben je nach Spinning-Current-Betriebsphase als Strom- oder Spannungsabgriff wirksam sind.

**Claims**

1. Vertical Hall sensor element (100), comprising:

a semiconductor substrate (102);
a semiconductor area (104) having a first conductivity type, the semiconductor area (104) extending from a main surface (102a) of the semiconductor substrate (102) into the substrate (102);
a plurality of contact areas (106a-e) at the main surface (102a) in the semiconductor area (104);
a plurality of non-conductive barrier areas (108a-d) extending originating from the main surface (102a) into the semiconductor area (104), wherein between adjacent contact areas one of the non-conductive barrier areas is arranged, and wherein the non-conductive barrier areas (108a-d) are implemented to keep an operating current $I_H$, which is fed in between two contact areas in the semiconductor area (104), remote from the main surface (102a); and
a cover layer arrangement (204; 302a-e) of a conductive material arranged over the main surface (102a) of the semiconductor substrate (102) with the semiconductor area (104) and electrically separated from the semiconductor area (104), wherein at least areas for contact terminals (A-D) for contacting the contact areas (106a-e) are left free, and wherein the cover layer arrangement (204; 302a-d) is controllable by applying a bias voltage;

wherein the semiconductor subject (102) comprises a second conductivity type, **characterized in that** the semiconductor area (104) is formed in the shape of a well originating from the main surface (102a) of the semiconductor substrate (102) in the semiconductor substrate (102).

2. Vertical Hall sensor element according to claim 1, wherein the non-conductive barrier area (108a-d) comprises a second conductivity type.

3. Vertical Hall sensor element according to claim 2, wherein the non-conductive barrier area (108a-d) extends into a depth of more than 25% of the depth T of the semiconductor area (104).

4. Vertical Hall sensor element according to one of the preceding claims, wherein the cover layer arrangement (204; 302a-d) comprises a plurality of adjacent, electrically separated partial cover areas (302a-e), wherein a partial cover area (302a-e) is associated with each contact area (106a-e).

5. Vertical Hall sensor element according to one of the preceding claims, wherein between the semiconductor area (104) and the cover layer arrangement an insulation layer (202) is arranged.

6. Method for magnetic field detection with a vertical Hall sensor element according to one of the preceding claims, comprising:

   controlling the cover layer arrangement by applying a bias voltage to the same.

7. Method according to claim 6, further comprising the following step:

   switching the contact areas (106a-e) in the spinning current operation, so that the same are effective as current or voltage taps depending on the spinning current operating phase.

8. Vertical Hall sensor element (100), comprising:

   a semiconductor substrate (102);
   a semiconductor area (104) having a first conductivity type, the semiconductor area (104) extending from a main surface (102a) of the semiconductor substrate (102) into the substrate (102);
   a plurality of conduct areas (106a-e) at the main surface (102a) in the semiconductor area (104);
   a plurality of non-conductive barrier areas (108a-d) extending originating from the main surface (102a) into the semiconductor area (104), wherein between each pair of the adjacent contact area one of the non-conductive barrier areas is arranged, and wherein the non-conductive barrier areas (108a-b) are implemented to keep an operating current $I_H$, which is fed in between two contact areas in the semiconductor area (104), remote from the main surface (102a); and **characterized by**
a plurality of adjacent, electrically separated partial cover areas (302a-e) of a conductive material over the semiconductor area (104) and electrically separated from the same, wherein several ones of the partial cover areas may be separately controlled by applying a separate bias voltage.

9. Vertical hall sensor element according to claim 8, wherein the semiconductor substrate (102) comprises a second conductivity type, wherein the semiconductor area (104) is formed in the form of a well originating from the main surface (102a) of the semiconductor substrate (102) in the semiconductor substrate (102).

10. Vertical hall sensor element according to claim 8 or 9, wherein the non-conductive barrier area (108a-d) comprises the second conductivity type.

11. Vertical hall sensor element according to claim 10, wherein the non-conductive barrier area (108a-d) extends into a depth of more than 25% of the depth T of the semiconductor area (104).

12. Vertical hall sensor element according to one of claims 8 to 11, wherein a partial cover area (302a-e) is associated with each contact area (106a-e).

13. Vertical hall sensor element according to one of claims 8 to 12, wherein between the semiconductor area (104) and the partial cover areas an insulation layer (202) is arranged.

14. Method for magnetic field detection with a vertical hall sensor element according to one of claims 8 to 13, comprising:

   separately controlling several ones of the partial cover areas by applying a separate bias voltage to the same.

15. Method according to claim 14, further comprising:

   switching the contact areas (106a-e) in the spinning-current operation, so that the same operate as current or voltage taps depending on the spinning current operating phase.

**Revendications**

1. Elément détecteur de Hall vertical (100), aux caractéristiques suivantes:

un substrat à semi-conducteur (102);

une zone de semi-conducteur (104) avec un premier type de conductivité, la zone de semi-conducteur (104) s'étendant d'une surface principale (102a) du substrat à semi-conducteur (102) dans le substrat (102);

une pluralité de zones de contact (106a à e) à la surface principale (102a) dans la zone de semi-conducteur (104);

une pluralité de zones de barrière non conductrices (108a à d) qui, partant de la surface principale (102a), s'étendent dans la zone de semi-conducteur (104), entre des zones de contact adjacentes étant disposée l'une des zones de barrière non conductrices, et les zones de barrière non conductrices (108a à d) étant réalisées de manière à maintenir un courant de fonctionnement $I_H$ alimenté entre deux zones de contact dans la zone de semi-conducteur (104) éloigné de la surface principale (102a); et

un aménagement de couche de recouvrement (204; 302a à e) constitué d'un matériau conducteur qui est disposé sur la surface principale (102a) du substrat à semi-conducteur (102) avec la zone de semi-conducteur (104) et électriquement isolé de la zone de semi-conducteur (104), au moins des zones de connexions de contact (A à D) pour la mise en contact des zones de contact (106a à e) étant laissées libres, et l'aménagement de couche de recouvrement (204; 302a à d) pouvant être activé par application d'une prétension;

le substrat à semi-conducteur (102) présentant un deuxième type de conductivité, **caractérisé par le fait que** la zone de semi-conducteur 104 est réalisée sous forme d'une cuvette partant de la surface principale (102a) du substrat à semi-conducteur (102) dans le substrat à semi-conducteur (102).

2. Elément détecteur de Hall vertical selon l'une des revendications 1, dans lequel la zone de barrière non conductrice (108a à d) présente le deuxième type de conductivité.

3. Elément détecteur de Hall vertical selon la revendication 2, dans lequel la zone de barrière non conductrice (108a à d) s'étend à une profondeur de plus de 25 % de la profondeur T de la zone de semi-conducteur (104).

4. Elément détecteur de Hall vertical selon l'une des revendications précédentes, dans lequel l'aménagement de couche de recouvrement (204; 302a à d) présente une pluralité de zones de recouvrement partielles (302a à e) adjacentes isolées électriquement l'une de l'autre, à chaque zone de contact (106a à e) étant associée une zone de recouvrement partielle (302a à e).

5. Elément détecteur de Hall vertical selon l'une des revendications précédentes, dans lequel est disposée, entre la zone de semi-conducteur (104) et l'aménagement de couche de recouvrement, une couche d'isolation (202).

6. Procédé de détection de champ magnétique avec un élément détecteur de Hall vertical selon l'une des revendications précédentes, aux étapes suivantes consistant à:

activer l'aménagement de couche de recouvrement par application d'une prétension sur celle-ci.

7. Procédé selon la revendication 6, par ailleurs à l'étape suivante consistant à:

commuter les zones de contact (106a à e) en fonctionnement à courant rotatif, de sorte qu'ils soient actifs, en fonction de la phase de fonctionnement à courant rotatif, comme prise de courant ou de tension.

8. Elément détecteur de Hall vertical (100), aux caractéristiques suivantes:

un substrat à semi-conducteur (102);

une zone de semi-conducteur (104) avec un premier type de conductivité, la zone de semi-conducteur (104) s'étendant d'une surface principale (102a) du substrat à semi-conducteur (102) dans le substrat (102);

une pluralité de zones de contact (106a à e) à la surface principale (102a) dans la zone de semi-conducteur (104);

une pluralité de zones de barrière non conductrices (108a à d) qui, partant de la surface principale (102a), s'étendent dans la zone de semi-conducteur (104), entre chaque paire de zones de contact adjacentes étant disposée l'une des zones de barrière non conductrices, et les zones de barrière non conductrices (108a à d) étant réalisées de manière à maintenir un courant de fonctionnement $I_H$ alimenté entre deux zones de contact dans la zone de semi-conducteur (104) éloigné de la surface principale (102a); **caractérisé par** une pluralité de zones de recouvrement partielles (302a à e) constitués d'un matériau conducteur sur la zone de semi-conducteur (104) et électriquement isolées de cette dernière, plusieurs des zones de recouvrement partielles pouvant être activées séparément par application d'une prétension séparée.

**9.** Elément détecteur de Hall vertical selon la revendication 8, dans lequel le substrat à semi-conducteur (102) présente une deuxième conductivité, la zone de semi-conducteur (104) étant réalisée sous forme d'une cuvette partant de la surface principale (102a) du substrat à semi-conducteur (102) dans le substrat à semi-conducteur (102).

**10.** Elément détecteur de Hall vertical selon la revendication 8 ou 9, dans lequel la zone de barrière non conductrice (108a à d) présente la deuxième conductivité.

**11.** Elément détecteur de Hall vertical selon la revendication 10, dans lequel la zone de barrière non conductrice (108a à d) s'étend à une profondeur de plus de 25 % de la profondeur T de la zone de semi-conducteur (104).

**12.** Elément détecteur de Hall vertical selon l'une des revendications 8 à 11, dans lequel est associée à chaque zone de contact (106a à e) une zone de recouvrement partielle (302a à e).

**13.** Elément détecteur de Hall vertical selon l'une des revendications 8 à 12, dans lequel est disposée, entre la zone de semi-conducteur (104) et les zones de recouvrement partielles, une couche d'isolation (202).

**14.** Procédé de détection de champ magnétique avec un élément détecteur de Hall vertical selon l'une des revendications 8 à 13, aux étapes suivantes consistant à:

activer séparément plusieurs zones de recouvrement partielles par application d'une prétension séparée sur celles-ci.

**15.** Procédé selon la revendication 14, par ailleurs avec l'étape suivante consistant à:

commuter les zones de contact (106a à e) en fonctionnement à courant rotatif, de sorte qu'ils soient actifs, en fonction de la phase de fonctionnement à courant rotatif, comme prise de courant ou de tension.

## FIG 1A

## FIG 1B

## FIG 2A

## FIG 2B

## FIG 3A

## FIG 3B

## FIG 4A (Stand der Technik)

400

B

406b 402

Breite W

A 406a 406c G

$U_{Hall}$

406d

404 D

Länge[L]

Y

Z ⊙ →X

⊙ B-Feld

## FIG 4B (Stand der Technik)

$U_H$ 420

A B C D

$I_H$ $I_H$

424a 426a 426b 426c 426d 426e

424

$U_{Hall}/2$ $U_{Hall}/2$

422 B-Feld

Tiefe [T] Länge[L]

Y

Z ⊙ →X

⊙

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 671773 A

- JP 2006024647 A

**In der Beschreibung aufgeführte Nicht-Patentliteratur**

- **R.S. Popovic.** The Hall-Effect Devices. *IEEE ELEC-TRON DEVICE LETTERS,* September 1984, vol. EDL-5 (9